# EUROPEAN PATENT APPLICATION

(11) **EP 4 600 687 A1**
(43) Date of publication of application: **13.08.2025**
(21) Application number: 24156653.8
(22) Date of filing: 08.02.2024
(51) Int. Cl.: G01S 7/02, G01S 13/931, H05K 9/00

(54) **RADAR DEVICE AND METHOD FOR MANUFACTURING THE SAME**

(71) Applicant: Aptiv Technologies AG, 8200 Schaffhausen (CH)
(72) Inventor: ZADWORNY, Bartlomiej Mateusz, 37-600 Lubaczów (PL)
(74) Representative: Manitz Finsterwald Patent- und Rechtsanwaltspartnerschaft mbB

(57) **Abstract**

A radar device for Autonomous Driving, AD, or Advanced Driver Assistant Systems, ADAS, applications for vehicles is provided. The device comprises a housing comprising a base and a cover, a radar unit mounted on a Printed Circuit Board, PCB, and a shielding covering the radar unit and configured to provide EMC, Electro Magnetic Compatibility, shielding to the radar unit. The shielding is fixedly attached to an inner bottom of the base. The base is provided with a supporting structure comprising a plurality of supporting elements configured to provide support the PCB and/or the shielding.

## Description

### FIELD

The present disclosure relates to a radar device for Autonomous Driving, AD, or Advanced Driver Assistant Systems, ADAS, applications for vehicles, and a method for manufacturing the same. The radar device comprises a housing, a radar unit, and a shielding.

### BACKGROUND

To ensure an optimal performance of a radar device, heat generated by the radar device has to be dissipated to the outside of the device. The generated heat is usually dissipated using heatsinks which are arranged within the radar device. Currently used solutions employ aluminum die-cast or stamped sheet metal heatsinks. Both variants of heatsinks can act as temperature dissipation as well as EMC shielding unit. In stamped heatsinks, an EMC metal spring is welded together with the heatsink, and provides an electrical connection between the heatsink and a ground path on PCB.

During assembly of the radar device, the heatsink usually is inserted before the PCB comprising the radar unit and then compressed during PCB press fit assembly.

Heat sinks considerably contribute to manufacturing costs of a radar device, as the piece price per heatsink is relatively large. In this respect, die-cast heatsinks are even more cost-intensive than stamped sheet metal heatsinks. Previous solutions to decrease heatsink cost therefore replaced die-cast heatsinks with stamped sheet metal heatsinks. Even though this lowered the piece price per heat sink, the use of stamped sheet metal heatsinks created problems during the press fit assembly due to their lower stiffness compared to die-cast heat sinks.

Accordingly, there is a need for a radar device which is cost-effective and easy to assemble and operates reliably.

### SUMMARY

The present disclosure provides in a first aspect a radar device and in a second aspect a method for manufacturing a radar device according to the independent claims. Embodiments are given in the sub-claims, the description and the drawings.

In a first aspect, the present disclosure is directed at a radar device for Autonomous Driving, AD, or Advanced Driver Assistant Systems, ADAS, applications for vehicles, the device comprising a housing comprising a base and a cover, a radar unit mounted on a Printed Circuit Board, PCB, and a shielding covering the radar unit and configured to provide EMC, Electro Magnetic Compatibility, shielding to the radar unit, wherein the shielding is fixedly attached to an inner bottom of the base, and wherein the base is provided with a supporting structure, the supporting structure comprising a plurality of supporting elements configured to provide support for the PCB and/or the shielding.

The radar device is not provided with a conventional heat sink. Instead, heat generated by the radar unit is dissipated to the outside by the housing, to which the shielding is fixedly attached. Heat generated by the radar unit is absorbed by the shielding and transferred to the base which efficiently dissipates the heat to the surroundings of the radar device. By omitting a dedicated heat sink component, the radar device can be manufactured more cost-efficiently than previous radar devices comprising a heat sink component. The reduced number of components reduces bill of materials (BOM) costs and enables shorter assembly times of the radar device.

The base and the cover may be rectangular shaped and form a flat housing of the radar device. The base comprises a flat bottom surface and four sidewalls. One of the side walls may be provided with an electro-mechanical connector for connecting the radar device for example with a vehicle or components thereof.

The base may comprise a plurality of compartments which may be separated from one another by supporting elements of the supporting structure. The supporting structure with the plurality of supporting elements provides a robust hard-stop for the PCB during assembly of the radar device. The supporting elements are formed of a stiff material and can for example include bars, bridges, ridges, pillars and platforms.

The supporting elements may protrude from the inner bottom of the base and/or may protrude from inner surfaces of the sidewalls of the base. The supporting elements may also be part of the base itself. The supporting elements may for example be bridges forming partition walls of different compartments of the base. The supporting elements may form ridges extending on inner sidewalls of the base for providing support for the PCB and/or the shielding. The supporting elements may also be a part of a sidewall of the base forming a horizontal platform to support the PCB and/or the shielding.

The plurality of supporting elements brace the PCB at various positions along the PCB's extension and ensure a safe stop and a secure retention of the PCB within the radar device. Due to the enhanced stiffness of the base and its supporting structure, a heat sink is no longer necessary for providing a robust support during PCB press fit assembly. The robustness of the base and its supporting structure thus ensures an unproblematic assembly and a flawless operation of the radar device.

The radar device is therefore cost-effective and easy to assemble and operates reliably.

According to an embodiment of the first aspect, the shielding is a stamped metal spring, in particular a stamped steel spring. In particular, the shielding is formed as a thin stamped metal spring. The metal spring is rectangular shaped and includes a flat bottom surface and four side walls. Adjacent side walls may not be connected to one another and may form edge openings which extend along the four side edges. Alternatively, adjacent side walls may be connected by a plurality of connecting elements like flanges or tabs.

The flat bottom surface is fixedly attached to the inner bottom of the base while the side walls extend from the flat bottom surface of the metal spring to a surface of the PCB. Support for the side walls of the metal spring is provided by the supporting elements of the supporting structure. At least one of the side walls is provided with an electrical connection with the ground path on the PCB.

The rectangular shaped metal spring and the PCB form a cavity which prevents the radar unit arranged within said cavity from being impacted by electromagnetic interference (EMI) or radio frequency (RF) interference. Thereby, only components which are sensitive to EMI or RF interference may be arranged on the PCB within the cavity formed by the shielding. Other components which are not affected by said interferences may be arranged outside the shielded area on the PCB. This allows to reduce size and cost of the shielding.

The main purpose of the shielding is therefore to provide an efficient EMC shielding to the radar unit. Furthermore, the stamped metal spring also provides for a compensation of manufacturing tolerances of the housing and the PCB components of the radar device. Due to its reduced thickness and reduced volume, heat capacity of the shielding is limited. Heat generated by the radar unit is absorbed by the shielding and quickly dissipated to the base of the housing. Stamped metal springs are easy to manufacture and provide a cost-effective EMC shielding to the radar unit.

According to an embodiment of the first aspect, the shielding is in contact with the inner bottom of the base. Accordingly, a contact area is formed between an outer surface of the shielding and the inner bottom of the base. Since the shielding and the base are in direct contact with one another, heat is dissipated from the shielding to the base, and finally to the outside of the radar device more efficiently.

According to an embodiment of the first aspect, at least 70% of an outer surface of the shielding on an opposite side of the PCB is in direct contact with the inner bottom of the base. Accordingly, a contact area comprising at least 70% of an outer surface of the shielding on an opposite side of the PCB is formed between an outer surface of the shielding and the inner bottom of the base. Since the shielding and the base are in direct contact with one another over a large fraction of the outer surface of the PCB, heat is dissipated from the shielding to the base, and finally to the outside of the radar device even more efficiently. To enhance said heat dissipation efficiency, an occupation fraction of the contact area of the outer surface of the shielding may also be larger than 70%, in particular 80%, 85% or 90%.

The shielding may furthermore be provided with a circular opening formed in a flat bottom surface of the shielding opposite the emitting and receiving components of the radar unit to further improve dissipation of heat generated by the radar unit.

According to an embodiment of the first aspect, the shielding is fixedly attached to the inner bottom of the base by a plurality of fastening means. The fastening means ensure that the shielding and the base are robustly connected to one another. In particular, the fastening means prevent that the shielding may shift with respect to the inner bottom of the base.

According to an embodiment of the first aspect, the plurality of fastening means is formed by a plurality of heat staked joints. Heat staked joints provide a robust and easy to implement attachment of the shielding to the base. The heat staking joints may be formed by heat staking of plastic pins provided on the inner bottom of the base, wherein the plastic bins have been inserted in corresponding openings in the shielding before heat staking is performed. For a shielding formed by a stamped metal spring, the openings are provided in a bottom surface of the metal spring. The plastic pins protrude from the inner bottom of the base over a length exceeding the thickness of the shielding to be attached to the base. This allows heat staking to be easily performed. After heat staking, the plastic pins form button-shaped rivets which fixedly connect the base and the shielding. The heat staking joints may be arranged along the edges of the inner bottom of the base. At least one of the heat staking joints may be arranged adjacent to the circular opening of the shielding.

According to an embodiment of the first aspect, the housing is made of plastic. A housing made of plastic is easy to manufacture and cost-effective. It can provide a necessary amount of stiffness for the base and its supporting structure for acting as a robust support for the PCB and a robust hard stop for the PCB during press fit assembly.

According to an embodiment of the first aspect, the housing is made of thermally conductive plastic, in particular a thermally conductive plastic having a thermal conductivity of at least 5 W/mK. The use of thermally conductive plastic enhances the capabilities of the radar device to dissipate heat. A housing made of thermally conductive plastic therefore ensures an efficient dissipation of heat and a reliable performance of radar devices with enhanced heat generation.

According to an embodiment of the first aspect, the base and the supporting structure are formed in one piece. This can enhance the structural stability and the stiffness of the supporting structure, ensuring a robust support for the PCB. The formation of the base and the supporting structure in one piece is very cost-effective and contributes to a further reduction of the manufacturing costs of the radar device.

In a second aspect, the present disclosure is directed at a method for manufacturing a radar device, the method comprising the steps of providing a housing comprising a cover and a base with a supporting structure comprising a plurality of supporting elements; inserting a shielding into the interior of the base, the shielding being configured to provide EMC, Electro Magnetic Compatibility, shielding to a radar unit; fixedly attaching the shielding to the inner bottom of the base; arranging a PCB comprising the radar unit on the supporting elements of the base, press-fit assembling the PCB; and attaching the cover to the base to close the housing.

Since the radar device is not provided with a heat sink, assembly times are shorter than in previous radar devices which have been equipped with such a dedicated heat dissipation component. By omitting the heat sink component, the radar device can therefore be manufactured more cost-efficiently than previous radar devices.

The reduced number of components reduces bill of materials (BOM) costs and enables shorter assembly times of the radar device.

The supporting structure with the plurality of supporting elements provides a robust hard-stop for the PCB during assembly of the radar device. The supporting elements are formed of a stiff material and can for example include bars, bridges, ridges, pillars and platforms. The plurality of supporting elements brace the PCB at various positions along the PCB's extension and ensure a safe stop and a secure retention of the PCB within the radar device. Due to the enhanced stiffness of the base and its supporting structure, a heat sink is no longer necessary for providing a robust support during PCB press fit assembly. The robustness of the base and its supporting structure thus ensures an unproblematic assembly and a flawless operation of the radar device.

The method for manufacturing a radar device therefore requires less components and enables shorter assembly times, and therefore ensures an unproblematic and cost-effective assembly of the radar device.

According to an embodiment of the second aspect, the shielding is a stamped metal spring, in particular a stamped steel spring. In particular, the shielding is formed as a thin stamped metal spring. The main purpose of the shielding is to provide an efficient EMC shielding to the radar unit. Furthermore, the stamped metal spring also provides for a compensation of manufacturing tolerances of the housing and the PCP components of the radar device. Due to its reduced thickness and reduced volume, heat capacity of the shielding is limited. Heat generated by the radar unit is absorbed by the shielding and quickly dissipated to the base of the housing. Stamped metal springs are easy to manufacture and provide a cost-effective EMC shielding to the radar unit.

According to an embodiment of the second aspect, the housing is made of plastic, in particular thermally conductive plastic. In particular the housing is made of thermally conductive plastic having a thermal conductivity of at least 5 W/mK. A housing made of plastic is easy to manufacture and cost-effective. It can provide a necessary amount of stiffness for the base and its supporting structure for acting as a robust support for the PCB and a robust hard stop for the PCB during press fit assembly. The use of thermally conductive plastic enhances the capabilities of the radar device to dissipate heat. A housing made of thermally conductive plastic therefore ensures an efficient dissipation of heat and a reliable performance also in radar devices with enhanced heat generation.

According to an embodiment of the second aspect, the shielding is fixedly attached to the inner bottom of the base by a plurality of fastening means. In particular, the shielding is in contact with the inner bottom of the base. Accordingly, a contact area is formed between an outer surface of the shielding and the inner bottom of the base. Since the shielding and the base are in direct contact with one another, heat is dissipated from the shielding to the base, and finally to the outside of the radar device more efficiently.

Thereby, at least 70% of an outer surface of the shielding on an opposite side of the PCB may be in direct contact with the inner bottom of the base. Accordingly, a contact area comprising at least 70% of an outer surface of the shielding on an opposite side of the PCB may be formed between an outer surface of the shielding and the inner bottom of the base. Since the shielding and the base are therefore in direct contact with one another over a large fraction of the outer surface of the PCB, heat is dissipated from the shielding to the base, and finally to the outside of the radar device of the housing even more efficiently. To enhance said heat dissipation efficiency, an occupation fraction of the contact area of the outer surface of the shielding may also be larger than 70%, in particular 80%, 85% or 90%.

The shielding may furthermore be provided with a circular opening formed in a flat bottom surface of the shielding opposite the emitting and receiving components of the radar unit to further improve dissipation of heat generated by the radar unit.

According to an embodiment of the second aspect, the inner bottom of the base is provided with a plurality of plastic pins, the shielding is provided with a plurality of corresponding openings, and the shielding is inserted into the interior of the base by inserting the plurality of openings in the plurality of corresponding plastic pins. The plurality of pins may protrude from the inner bottom of the base and may be formed in one piece with the base. The openings may be formed cost-effectively as holes during the formation of the shielding. For a shielding formed by a stamped metal spring, the openings are provided in a bottom surface of the metal spring.

According to an embodiment of the second aspect, the shielding is fixedly attached to the inner bottom of the base by heat staking of the plastic pins after the shielding is inserted into the interior of the base. The plastic pins protrude from the inner bottom of the base over a length exceeding the thickness of the shielding to be attached to the base. This allows heat staking to be easily performed. After heat staking, the plastic pins form button-shaped rivets which fixedly connect the base and the shielding. The heat staking joints may be arranged along the edges of the inner bottom of the base. At least one of the heat staking joints may be arranged adjacent to the circular opening of the shielding. After heat staking, the plastic pins form robust fastening means for connecting the base and the shielding.

Heat staked joints provide a robust and easy to implement attachment of the shielding to the base. The present disclosure is however not restricted to an attachment by heat staking joints, other methods for fixedly attaching the shielding to the base are possible as well.

### DRAWINGS

Exemplary embodiments and functions of the present disclosure are described herein in conjunction with the following drawings, showing schematically:
- Fig. 1: Section view of an embodiment of a radar device
- Fig. 2: Perspective view of the radar device of Fig. 1 with translucent housing
- Fig. 3: Another perspective view of the radar device of Fig. 1

### DETAILED DESCRIPTION

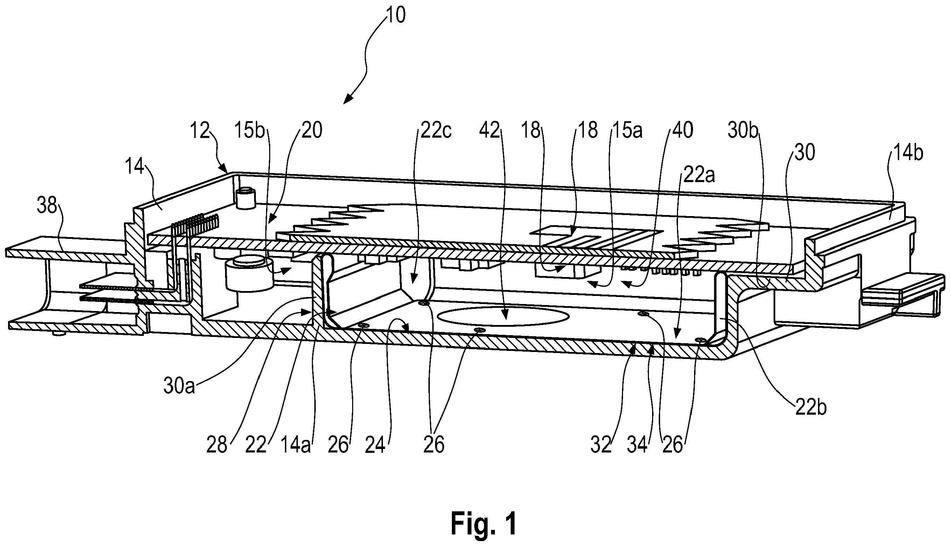

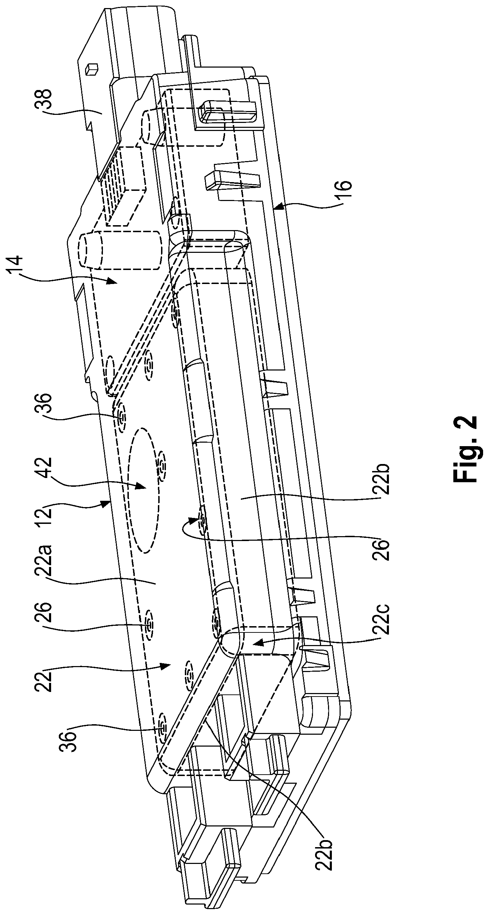

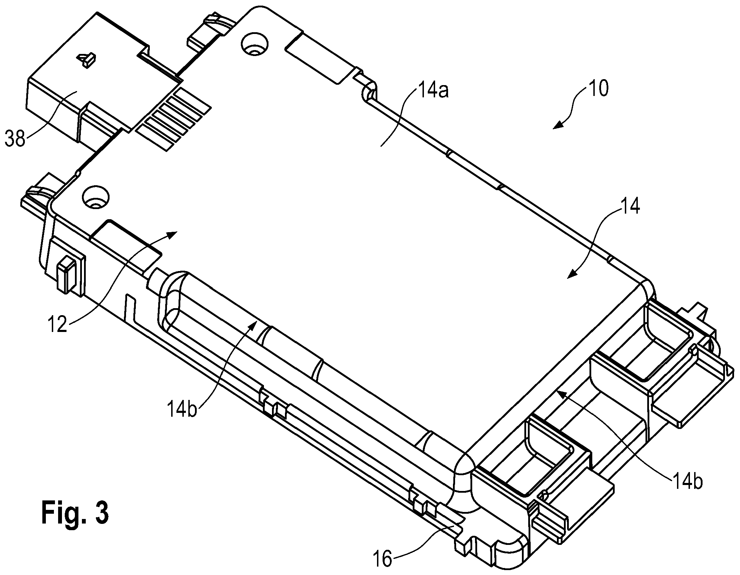

Fig. 1 depicts a section view of an embodiment of a radar device 10. Figs. 2 and 3 depict two perspective views of the embodiment of Fig. 1, with Fig. 2 showing the radar device 10 with translucent housing.

The radar device 10 comprises a housing 12 including a base 14 and a cover 16, a radar unit 18 mounted on a Printed Circuit Board (PCB) 20 and a shielding 22 covering the radar unit 18 and configured to provide EMC (Electro Magnetic Compatibility) shielding to the radar unit 22.

The base 14 and the cover 16 are rectangular shaped and form a flat housing 12 of the radar device 10. The base 14 comprises a flat bottom surface 14a and four sidewalls 14b. One of the side walls 14b is provided with an electro-mechanical connector 38 for connecting the radar device 10 for example with a not shown vehicle or components thereof. The base 14 comprises a plurality of compartments 15a, 15b which are separated from one another by supporting elements 30 of the supporting structure 28.

The shielding 22 is fixedly attached to the inner bottom 24 of the base 14 by a plurality of fastening means 26. The base 14 is provided with a supporting structure 28 comprising a plurality of supporting elements 30 configured to provide support for the PCB 20.

The shielding 22 is a thin stamped metal spring, in particular a thin stamped steel spring. The metal spring is rectangular shaped and includes a flat bottom surface 22a and four side walls 22b. In this embodiment, adjacent side walls are not connected to one another and form edge openings 22c which extend along the four side edges. Alternatively, adjacent side walls may also be connected by a plurality of connecting elements like flanges or tabs.

The flat bottom surface 22a is fixedly attached to the inner bottom 24 of the base 14 while the side walls 22b extend from the flat bottom surface 22a of the metal spring 22 to a surface of the PCB 20. Support for the side walls 22b of the shielding 22 is provided by the supporting elements 30 of the supporting structure 28. At least one of the side walls 22a is provided with an electrical connection with the ground path on the PCB 20.

The rectangular shaped metal spring 22 and the PCB 20 form a cavity 40 which prevents the radar unit 18 arranged within said cavity 40 from being impacted by electromagnetic interference (EMI) or radio frequency (RF) interference. Thereby, only components which are sensitive to EMI or RF interference are arranged on the PCB 20 within the cavity 40 formed by the shielding 22. Other components which are not affected by said interferences are arranged outside the shielded area on the PCB 20.

The main purpose of the shielding 22 is to provide an efficient EMC shielding to the radar unit 18. Furthermore, the stamped metal spring 22 also provides for a compensation of manufacturing tolerances of the housing 12 and the PCP 20 components of the radar device 10.

The shielding 22 is in direct contact with the inner bottom 24 of the base 14. Accordingly, a contact area 32 is formed between an outer surface 34 of the shielding 22 and the inner bottom 24 of the base 14. The contact area 32 comprises at least 70% of an outer surface 34 of the shielding 22 on an opposite side of the PCB 20. This ensures an efficient dissipation of heat generated by the radar unit 18 from the shielding 22 to the base 14, and finally to the outside of the radar device 10. The shielding 22 is furthermore provided with a circular opening 42 formed in the flat bottom surface 22a of the shielding 22 opposite the emitting and receiving components of the radar unit 18 to further improve dissipation of heat generated by the radar unit 18.

The housing 12 is made of plastic, in particular thermally conductive plastic. The plastic material provides a necessary amount of stiffness for the base 14 and its supporting structure 28. The use of thermally conductive plastic enhances the capabilities of the radar device 10 to dissipate heat. A housing 12 made of thermally conductive plastic therefore ensures an efficient dissipation of heat and a reliable performance also in radar devices 10 with enhanced heat generation.

The shielding 22 is fixedly attached to the base 14 by a plurality of heat staked joints 26 which provide a robust attachment of the shielding 22 to the base 14. The heat staked joints 26 are formed by heat staking of not shown plastic pins provided on the inner bottom 24 of the base 14, wherein the plastic pins have been inserted in corresponding openings 36 in the shielding 22 before heat staking is performed.

Thereby, the plastic pins protrude from the inner bottom 24 of the base 14 over a length exceeding the thickness of the shielding 22 to be attached to the base 14. This allows heat staking to be easily performed. After heat staking, the plastic pins form button-shaped rivets 26 which fixedly connect the base 14 and the shielding 22. The heat staking joints 26 are arranged along the edges of the inner bottom 24 of the base 14. One further heat staking joint 26 is arranged adjacent to the circular opening 42 of the shielding 22.

The base 14 and the supporting structure 28 are formed in one piece which enhances the structural stability and the stiffness of the supporting structure 28, and ensures a robust support for the PCB 20. The supporting structure 28 comprises a plurality of supporting elements 30 which can for example include bars, bridges 30a, ridges, pillars and platforms 30b.

The supporting elements 30 may protrude from the inner bottom 24 of the base 14 and/or may protrude from inner surfaces of the sidewalls 14b of the base 14. The supporting elements 30 may also be part of the base 14 itself. The supporting elements 30 comprise at least one bridge 30a forming a partition wall of the compartments 15a, 15b of the base 14. The bridge 30a provides support for the PCB 20 and the shielding 22. The supporting elements 30 further comprise a horizontal platform 30b as part of a sidewall 14b of the base 14 to support the PCB 20 and/or the shielding 22.

The plurality of supporting elements 30 brace the PCB 20 at various positions along the PCB's extension and ensure a safe stop and a secure retention of the PCB 20 within the radar device 10. The supporting structure 28 with its supporting elements 30 provide a robust support for the PCB 20 and a robust hard stop for the PCB 20 during press fit assembly.

During assembly of the radar device 10, the shielding 22 is inserted into the interior of the base 14, and fixedly attached to the base 14 by heat staking as described above. In a further step, the PCB 20 is arranged on the supporting elements 30 of the base 14 and press-fit assembling of the PCB is performed. During press-fitting, the supporting structure 28 and its supporting elements 30 provide a robust hard-stop for the PCB 20. After press-fitting, the cover 16 is attached to the base 14 to close the housing 12 and finish the assembly of the radar device 10.

Due to the enhanced stiffness of the base 14 and its supporting structure 28, a heat sink is no longer necessary for providing a robust support during PCB 20 press fit assembly. The robustness of the base 14 and its supporting structure 28 thus ensures an unproblematic assembly and a flawless operation of the radar device 10.

By omitting a dedicated heat sink component, the radar device 10 can be manufactured more cost-efficiently than previous radar devices comprising a heat sink component. The reduced number of components reduces bill of materials (BOM) costs and enables shorter assembly times of the radar device 10.

The method for manufacturing a radar device 10 requires less components and enables shorter assembly times, and therefore ensures an unproblematic and cost-effective assembly of the radar device 10.

### Reference numeral list

- 10: Radar device
- 12: Housing
- 14: Base
- 14a: Bottom surface of the base
- 14b: Side wall of the base
- 15a: Compartment
- 15b: Compartment
- 16: Cover
- 18: Radar Unit
- 20: PCB
- 22: Shielding
- 22a: Bottom surface of the shielding
- 22b: Sidewall of the shielding
- 22c: Edge opening of the shielding
- 24: Inner bottom of the base
- 26: Fastening means / Heat staked joint
- 28: Supporting structure
- 30: Supporting element
- 30a: Bridge
- 30b: Platform
- 32: Contact area
- 34: Outer surface of the shielding
- 36: Opening
- 38: Electro-mechanical connector
- 40: Cavity
- 42: Circular opening

## Claims

1. A radar device (10) for Autonomous Driving, AD, or Advanced Driver Assistant Systems, ADAS, applications for vehicles, the device comprising:
a housing (12) comprising a base (14) and a cover (16),
a radar unit (18) mounted on a Printed Circuit Board, PCB (20), and
a shielding (22) covering the radar unit (18) and configured to provide EMC, Electro Magnetic Compatibility, shielding to the radar unit (18),
wherein
the shielding (22) is fixedly attached to an inner bottom (24) of the base (14), and
the base (14) is provided with a supporting structure (28), the supporting structure (28) comprising a plurality of supporting elements (30) configured to provide support for the PCB (20) and/or the shielding.

2. The radar device (10) of claim 1, wherein the shielding (22) is a stamped metal spring, in particular a stamped steel spring.

3. The radar device (10) of claim 1 or 2, wherein the shielding (22) is in contact with the inner bottom (24) of the base (14).

4. The radar device (10) of claim 3, wherein at least 70% of an outer surface (34) of the shielding (22) on an opposite side of the PCB (20) is in direct contact with the inner bottom (24) of the base (14).

5. The radar device (10) of any one of claims 1 to 4, wherein the shielding (22) is fixedly attached to the inner bottom (24) of the base (14) by a plurality of fastening means (26).

6. The radar device (10) of any one of claims 1 to 5, wherein the plurality of fastening means (26) is formed by a plurality of heat staked joints.

7. The radar device (10) of any one of claims 1 to 5,
wherein the housing (12) is made of plastic.

8. The radar device (10) of claim 7,
wherein the housing (12) is made of thermally conductive plastic, in particular a thermally conductive plastic having a thermal conductivity of at least 5 W/mK.

9. The radar device (10) of any one of claims 1 to 8,
wherein the base (14) and the supporting structure (28) are formed in one piece.

10. A method for manufacturing a radar device (10), in particular according to any one of claims 1 to 9, the method comprising the steps of:
- providing a housing (12) comprising a cover (16) and a base (14) with a supporting structure (28) comprising a plurality of supporting elements (30),
- inserting a shielding (22) into the interior of the base (14), the shielding (22) being configured to provide EMC, Electro Magnetic Compatibility, shielding to a radar unit (18),
- fixedly attaching the shielding (22) to an inner bottom (24) of the base (14),
- arranging a PCB (20) comprising the radar unit (18) on the supporting elements (30) of the base (14),
- press-fit assembling the PCB (20),
- attaching the cover (16) to the base (14) to close the housing (12).

11. The method of claim 10, wherein the shielding (22) is a stamped metal spring, in particular a stamped steel spring.

12. The method of claim 10 or 11, wherein the housing (12) is made of plastic, in particular thermally conductive plastic.

13. The method of any one of claims 10 to 12, wherein the shielding (22) is fixedly attached to the inner bottom (24) of the base (14) by a plurality of fastening means (26).

14. The method of any one of claims 10 to 14, wherein the inner bottom (24) of the base (14) is provided with a plurality of plastic pins, wherein the shielding (22) is provided with a plurality of corresponding openings (36), and wherein the shielding (22) is inserted into the interior of the base (14) by inserting the plurality of openings (36) in the plurality of corresponding plastic pins.

15. The method of claim 14, wherein the shielding (22) is fixedly attached to the inner bottom (24) of the base (14) by heat staking of the plastic pins after the shielding (22) is inserted into the interior of the base (14).

## Amended claims

### Amended claims in accordance with Rule 137(2) EPC.

1. A radar device (10) for Autonomous Driving, AD, or Advanced Driver Assistant Systems, ADAS, applications for vehicles, the device comprising:
a housing (12) comprising a base (14) and a cover (16),
a radar unit (18) mounted on a Printed Circuit Board, PCB (20), and
a shielding (22) covering the radar unit (18) and configured to provide EMC, Electro Magnetic Compatibility, shielding to the radar unit (18),
wherein
the base (14) is provided with a supporting structure (28), the supporting structure (28) comprising a plurality of supporting elements (30) configured to provide support for the PCB (20) and/or the shielding,
**characterized in that**
the shielding (22) is fixedly attached to an inner bottom (24) of the base (14).

2. The radar device (10) of claim 1, wherein the shielding (22) is a stamped metal spring, in particular a stamped steel spring.

3. The radar device (10) of claim 1 or 2, wherein the shielding (22) is in contact with the inner bottom (24) of the base (14).

4. The radar device (10) of claim 3, wherein at least 70% of an outer surface (34) of the shielding (22) on an opposite side of the PCB (20) is in direct contact with the inner bottom (24) of the base (14).

5. The radar device (10) of any one of claims 1 to 4, wherein the shielding (22) is fixedly attached to the inner bottom (24) of the base (14) by a plurality of fastening means (26).

6. The radar device (10) of claim 5, wherein the plurality of fastening means (26) is formed by a plurality of heat staked joints.

7. The radar device (10) of any one of claims 1 to 5,
wherein the housing (12) is made of plastic.

8. The radar device (10) of claim 7,
wherein the housing (12) is made of thermally conductive plastic, in particular a thermally conductive plastic having a thermal conductivity of at least 5 W/mK.

9. The radar device (10) of any one of claims 1 to 8,
wherein the base (14) and the supporting structure (28) are formed in one piece.

10. A method for manufacturing a radar device (10), in particular according to any one of claims 1 to 9, the method comprising the steps of:
- providing a housing (12) comprising a cover (16) and a base (14) with a supporting structure (28) comprising a plurality of supporting elements (30),
- inserting a shielding (22) into the interior of the base (14), the shielding (22) being configured to provide EMC, Electro Magnetic Compatibility, shielding to a radar unit (18),
- fixedly attaching the shielding (22) to an inner bottom (24) of the base (14),
- arranging a PCB (20) comprising the radar unit (18) on the supporting elements (30) of the base (14),
- press-fit assembling the PCB (20),
- attaching the cover (16) to the base (14) to close the housing (12).

11. The method of claim 10, wherein the shielding (22) is a stamped metal spring, in particular a stamped steel spring.

12. The method of claim 10 or 11, wherein the housing (12) is made of plastic, in particular thermally conductive plastic.

13. The method of any one of claims 10 to 12, wherein the shielding (22) is fixedly attached to the inner bottom (24) of the base (14) by a plurality of fastening means (26).

14. The method of any one of claims 10 to 13, wherein the inner bottom (24) of the base (14) is provided with a plurality of plastic pins, wherein the shielding (22) is provided with a plurality of corresponding openings (36), and wherein the shielding (22) is inserted into the interior of the base (14) by inserting the plurality of openings (36) in the plurality of corresponding plastic pins.

15. The method of claim 14, wherein the shielding (22) is fixedly attached to the inner bottom (24) of the base (14) by heat staking of the plastic pins after the shielding (22) is inserted into the interior of the base (14).
